# EUROPEAN PATENT APPLICATION

(11) **EP 2 159 832 A1**
(43) Date of publication of application: **03.03.2010**
(21) Application number: 08777183.8
(22) Date of filing: 13.06.2008
(51) Int. Cl.: H01L 21/318, C23C 14/12, H01L 21/312, H01L 21/768, H01L 23/522

(54) **PROCESS FOR PRODUCING SEMICONDUCTOR DEVICE, INSULATING FILM FOR SEMICONDUCTOR DEVICE, AND APPARATUS FOR PRODUCING THE INSULATING FILM**

(30) Priority: 18.06.2007 JP 2007159739
(71) Applicant: Mitsubishi Heavy Industries, Ltd., Tokyo 108-8215 (JP); Mitsubishi Electric Corporation, Chiyoda-ku Tokyo 100-8310 (JP); Nippon Shokubai Co., Ltd., Osaka-shi, Osaka 541-0043 (JP)
(72) Inventor: FUJIWARA, Toshihito, Takasago-shi Hyogo 676-8686 (JP); NISHIMORI, Toshihiko, Takasago-shi Hyogo 676-8686 (JP); WATANABE, Toshiya, Yokohama-shi Kanagawa 236-8515 (JP); YASUDA, Naoki, Tokyo 100-8310 (JP); NOBUTOKI, Hideharu, Tokyo 100-8310 (JP); KUMADA, Teruhiko, Tokyo 100-8310 (JP); MIZUSHIMA, Chiho, Suita-shi Osaka 564-8512 (JP); KAMIYAMA, Takuya, Suita-shi Osaka 564-8512 (JP); YAMAMOTO, Tetsuya, Suita-shi Osaka 564-8512 (JP)
(74) Representative: HOFFMANN EITLE
(86) International application number: PCT/JP2008/060821
(87) International publication number: WO 2008/156029

(57) **Abstract**

An object to provide an insulating film for a semiconductor device, which has characteristics of low permittivity, a low leak current, and high mechanical strength, undergoes small time-dependent change of these characteristics, and has excellent water resistance, and to provide a manufacturing apparatus of the same, and a manufacturing method of the semiconductor device using the insulating film. The production process comprises a film forming step of supplying a mixed gas containing a carrier gas and a raw material gas, which is a gasified material having borazine skeletal molecules, into a chamber, causing the mixed gas to be in a plasma state, applying a bias to the substrate placed in the chamber, and carrying out gas-phase polymerization by using the borazine skeletal molecule as a fundamental unit so as to form the insulating film on the substrate; and a reaction promoting step of, after the film forming step, bringing the bias applied to the substrate to a different magnitude from the bias in the film forming step, supplying the mixed gas while gradually reducing only the raw material gas, which is the gasified material having the borazine skeletal molecules, treating the insulating film with a plasma mainly comprising the carrier gas.

## Description

### TECHNICAL FIELD

The present invention relates to a manufacturing method of a semiconductor device having an insulating film for the semiconductor device used for an interlayer insulating film, barrier metal layer, etch stopper layer, passivation layer, hard mask, etc., to the insulating film for the semiconductor device, and to a manufacturing apparatus of the same.

### BACKGROUND ART

Recently, along with development of information communication societies, the amount of information processing has been increased, and increase in the degree of integration and speed-up of LSIs (Large Scale Integrated circuits) which carry out the signal processing thereof are required. For the increase in the degree of integration and speed-up of the LSIs, miniaturization thereof is underway; however, along with miniaturization, loss due to the capacity of an insulating layer between wirings has become a problem, and reducing the permittivity of the insulating layer has become necessary. As the insulating layer, in addition to the reduction in the permittivity, high mechanical strength is required for processing of the LSIs. Moreover, although resistance of wiring is reduced by changing the material of the wiring from an aluminium alloy to copper, a thin film such as a barrier film that contacts the wiring is also required to have a diffusion preventing function against metal, particularly, copper, not to mention reduction in the permittivity.

In view of the above described problems, as the materials of the insulating layer of the next generation, various materials such as a fluorine-containing silicon oxide film (SiOF), porous silicon oxide film, fluorine-containing polyimide film, porous organic coating film, and SiC-based film have been studied.

However, when an interlayer insulating film is formed by SiOF, the permittivity of the interlayer insulating film is low compared with a conventional one; however, since the permittivity thereof is about 3.2 to 3.5, reduction of the capacity between wirings, prevention of signal propagation delay of wiring, and so on cannot be sufficiently achieved.
Meanwhile, when an interlayer insulating film is formed by an organic compound material, a permittivity of 2.7 has been achieved by the film in which fluorine atoms are introduced to polyimide or by arylether-based polymers; however, it is not sufficient yet. A permittivity of 2.4 can be achieved by a vapor-deposited film of parylene; however, since obtained heat resistance is no more than about 200 to 300°C, it restricts the manufacturing processes of semiconductor elements.
Meanwhile, the values of 2.0 to 2.5 have been reported as the permittivity, of porous SiO₂ films; however, since the porosity thereof is high, there are problems that the mechanical strength (resistance to CMP polishing process) thereof is weak and the diameters of pores are varied.
Furthermore, since these polymer materials and the porous SiO₂ films have inferior heat conductivity than conventional SiO₂ interlayer insulating films, wiring life deterioration (electro-migration) due to increase in the wiring temperature has been concerned about.
Meanwhile, copper diffuses into these insulating films due to electric fields; therefore, when copper wiring is applied, the surface of copper has to be coated by a diffusion preventing film. Therefore, the upper surface and side walls of copper wiring are coated with electrically-conductive barrier metal, and the upper surface is coated with insulating silicon nitride. However, the permittivity of the silicon nitride film is about 7, and the resistance of the barrier metal is much higher than that of copper. As a result, the resistance value of the whole wiring increases; therefore, there has been a problem that speed-up of semiconductor devices is restricted.
Meanwhile, when a low-permittivity insulating film is used, a conventional silicon oxide film having good heat conductivity is used in the level of connecting holes, which connect upper and lower wirings, in order to avoid reliability deterioration. Therefore, wiring capacity is further increased. The increase in the wiring capacity causes signal delay, and there has been a problem that speed-up of semiconductor devices is restricted.

In this manner, the above described insulating layer materials are not at the levels that sufficiently satisfy all of the permittivity reduction, the high mechanical strength, and the metal diffusion preventing function and still have many problems to be solved when applied as an insulating film, for example, low heat resistance and low heat conductivity.
Patent Document 1: Japanese Patent No. 3508629
Patent Document 2: Japanese Patent No. 3778045

### DISCLOSURE OF THE INVENTION

### PROBLEMS TO BE SOLVED BY THE INVENTION

Law-perznittivity materials having borazine skeletal molecules in the molecules of inorganic or organic materials are described in Patent Documents 1 and 2 as the materials having low permittivity and heat resistance that solve the above described problems. However, since the above described low-permittivity materials have hydrolyzable property, there has been problems that expansion of the film and deterioration of the specific permittivity and leak current is caused due to time-dependent change; and techniques capable of manufacturing a stable borazine skeleton structure film in which these characteristics are not largely changed along with time elapse have been required. Furthermore, in order to obtain further lower permittivity, cross-linking reactions between borazine skeletons have to be sufficiently carried out in a borazine skeleton structure film, and the techniques capable of sufficiently carrying out the cross-linking reactions have been required.

The present invention has been accomplished in view of the above described problems, and it is an object of the present invention to provide an insulating film for a semiconductor device, which has characteristics of low permittivity, a low leak current, and high mechanical strength, undergoes small time-dependent change of these characteristics, and has excellent water resistance, and to provide a manufacturing apparatus of the same, and a manufacturing method of the semiconductor device using the insulating film for the semiconductor device.

### MEANS FOR SOLVING THE PROBLEMS

A manufacturing method of a semiconductor device according to a first invention which solves the above described problems, comprising:
a film forming step of supplying a mixed gas containing a carrier gas and a rawmaterial gas, which is a gasified material having borazine skeletal molecules shown in a chemical formula described below, into a chamber,
causing electromagnetic waves to enter the chamber so as to cause the mixed gas to be in a plasma state, and
carrying out gas-phase polymerization by using the borazine skeletal molecule as a fundamental unit so as to form an insulating film for the semiconductor device on a substrate placed in the chamber; and
a reaction promoting step of promoting cross-linking reaction of the borazine skeletal molecules in the formed insulating film for the semiconductor device after the film forming step. 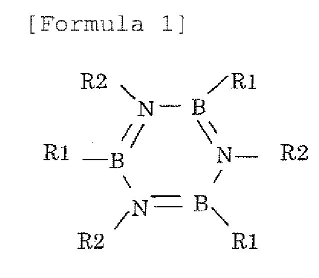
Herein, each of R1 and R2 in the above described chemical formula is a hydrogen atom or an alkyl group, an alkenyl group, a monoalkylamino group, or a dialkylamino group, which are having a carbon number of 5 or less, and R1 and R2 may be the same or different from each other. However, the cases in which all of R1 and R2 are hydrogen atoms are excluded.

A manufacturing method of a semiconductor device according to a second invention which solves the above described problems is the manufacturing method of the semiconductor device according to the above described first invention, wherein
the carrier gas comprises a gas of at least one species of helium, argon, nitrogen, hydrogen, oxygen, ammonia, and methane and may be the same or different in the film forming step and the reaction promoting step.

A manufacturing method of a semiconductor device according to a third invention which solves the above described problems is the manufacturing method of the semiconductor device according to the above described first or second invention, wherein
in the film forming step, a bias is applied to the substrate.

A manufacturing method of a semiconductor device according to a fourth invention which solves the above described problems is the manufacturing method of the semiconductor device according to any of the above described third invention, wherein
power of the bias in the film forming step is equal to or less than 3180 W/m².

A manufacturing method of a semiconductor device according to a fifth invention which solves the above described problems is the manufacturing method of the semiconductor device according to any of the above described first to fourth inventions, wherein
in the reaction promoting step, a bias is applied to the substrate, and
the cross-linking reaction of the borazine skeletal molecules in the formed insulating film for the semiconductor device is promoted by plasma mainly comprising a gas not containing the raw material gas.

A manufacturing method of a semiconductor device according to a sixth invention which solves the above described problems is the manufacturing method of the semiconductor device according to any of the above described first to fourth inventions, wherein
in the reaction promoting step, a bias is applied to the substrate,
only the raw material gas, which is the gasified material having the borazine skeletal molecules, is gradually reduced while supplying the mixed gas, and
the cross-linking reaction of the borazine skeletal molecules in the formed insulating film for the semiconductor device is promoted by plasma mainly comprising the carrier gas.

A manufacturing method of a semiconductor device according to a seventh invention which solves the above described problems is the manufacturing method of the semiconductor device according to the above described fifth or sixth invention, wherein
power of the bias in the reaction promoting step has magnitude different from the bias in the film forming step, and the product of the power and application time is equal to or more than 95550 w/m² second.

The manufacturing method of a semiconductor device according to an eighth invention which solves the above described problems is the manufacturing method of the semiconductor device according to any of the above described first to seventh inventions, wherein
power of the electromagnetic waves in the film forming step and the reaction promoting step is equal to or more than 1590 W/m² and equal to or less than 127400 W/m².

A manufacturing method of a semiconductor device according to a ninth invention which solves the above described problems is the manufacturing method of the semiconductor device according to any of the above described first to eighth inventions, wherein
the substrate is disposed at a height position where an electron density in the vicinity of the substrate is equal to or less than one twentieth of a highest electron density in the plasma.

A manufacturing method of semiconductor device according to a tenth invention which solves the above described problems is the manufacturing method of the semiconductor device according to any of the above described first to fourth inventions, wherein
in the reaction promoting step, the cross-linking reaction of the borazine skeletal molecules in the formed insulating film for the semiconductor device is promoted by thermal treatment.

A manufacturing method of a semiconductor device according to an eleventh invention which solves the above described problems is the manufacturing method of the semiconductor device according to any of the above described first to fourth inventions, wherein
in the reaction promoting step, the cross-linking reaction of the borazine skeletal molecules in the formed insulating film for the semiconductor device is promoted by ultraviolet ray radiation treatment.

A manufacturing method of a semiconductor device according to a twelfth invention which solves the above described problems is the manufacturing method of the semiconductor device according to any of the above described first to fourth inventions, wherein
in the reaction promoting step, the cross-linking reaction of the borazine skeletal molecules in the formed insulating film for the semiconductor device is promoted by electron beam radiation treatment.

A manufacturing method of a semiconductor device according to a thirteenth invention which solves the above described problems is the manufacturing method of the semiconductor device according to any of the above described first to fourth inventions, wherein
in the reaction promoting step, the cross-linking reaction of the borazine skeletal molecules in the formed insulating film for the semiconductor device is promoted by ion radiation treatment.

A semiconductor device manufacturing apparatus according to a fourteenth invention which solves the above described problems, comprising:
gas supplying means for supplying a mixed gas containing a carrier gas and a raw material gas, which is a gasified material having borazine skeletal molecules shown in a chemical formula described below, into a chamber;
plasma generating means for causing electromagnetic waves to enter the chamber so as to cause the mixed gas to be in a plasma state;
promoting means for promoting cross-linking reaction of the borazine skeletal molecules; and
controlling means for controlling the gas supplying means, the plasma generating means, and the promoting means; wherein
the controlling means
carries out a film forming step of supplying the mixed gas into the chamber by the gas supplying means,
causing the mixed gas to be in the plasma state by the plasma generating means, and
forming a film on a substrate placed in the chamber as an insulating film for the semiconductor device by carrying out gas-phase polymerization by using the borazine skeletal molecule as a fundamental unit; and
carries out a reaction promoting step of promoting the cross-linking reaction of the borazine skeletal molecules in the formed insulating film for the semiconductor device by the promoting means after the film forming step. 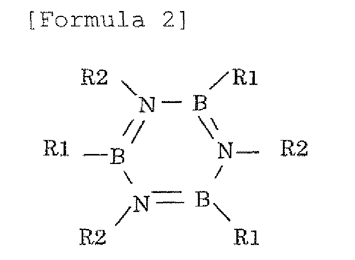
Herein, each of R1 and R2 in the above described chemical formula is a hydrogen atom or an alkyl group, an alkenyl group, a monoalkylamino group, or a dialkylamino group, which are having a carbon number of 5 or less, and R1 and R2 may be the same or different from each other. However, the cases in which all of R1 and R2 are hydrogen atoms are excluded.

A semiconductor device manufacturing apparatus according to a fifteenth invention which solves the above described problems is the semiconductor device manufacturing apparatus according to the above described fourteenth invention, wherein
the carrier gas comprises a gas of at least one species of helium, argon, nitrogen, hydrogen, oxygen, ammonia, and methane and may be the same or different in the film forming step and the reaction promoting step.

A semiconductor device manufacturing apparatus according to a sixteenth invention which solves the above described problems is the semiconductor device manufacturing apparatus according to the above described fourteenth or fifteenth invention, further comprising:
bias applying means for applying bias to the substrate is provided, and
wherein the controlling means applies the bias to the substrate by the bias applying means in the film forming step.

A semiconductor device manufacturing apparatus according to a seventeenth invention which solves the above described problems is the semiconductor device manufacturing apparatus according to the above described sixteenth invention, wherein
the bias applying means causes power of the bias in the film forming step to be equal to or less than 3180 W/m².

A semiconductor device manufacturing apparatus according to an eighteenth invention which solves the above described problems is the semiconductor device manufacturing apparatus according to any of the above described fourteenth to seventeenth inventions, wherein
as the promoting means in the reaction promoting step,
the controlling means applies a bias to the substrate by the bias applying means,
generates plasma mainly comprising a gas not containing the raw material gas by the gas supplying means and the plasma generating means, and
promotes the cross-linking reaction of the borazine skeletal molecules in the formed insulating film for the semiconductor device by the plasma.

A semiconductor device manufacturing apparatus according to a nineteenth invention which solves the above described problems is the semiconductor device manufacturing apparatus according to any of the above described fourteenth to seventeenth inventions, wherein
as the promoting means in the reaction promoting step,
the controlling means applies a bias to the substrate by the bias applying means,
gradually reduces only supply of the raw material gas, which is the gasified borazine skeletal molecules, by the gas supplying means,
generates plasma mainly comprising the carrier gas by the plasma generating means, and
promotes the cross-linking reaction of the borazine skeletal molecules in the formed insulating film for the semiconductor device by the plasma.

A semiconductor device manufacturing apparatus according to a twentieth invention which solves the above described problems is the semiconductor device manufacturing apparatus according to the above described eighteenth or nineteenth invention, wherein
the bias applying means causes power of the bias in the reaction promoting step to have magnitude different from the bias in the film forming step and causes the product of the power and application time to be equal to or more than 95550 W/m²·second.

A semiconductor device manufacturing apparatus according to a twenty first invention which solves the above described problems is the semiconductor device manufacturing apparatus according to any of the above described fourteenth to twentieth inventions, wherein
the plasma generating means causes power of the electromagnetic waves in the film forming step and the reaction promoting step to be equal to or more than 1590 W/m² and equal to or less than 127400 W/m².

A semiconductor device manufacturing apparatus according to a twenty second invention which solves the above described problems is the semiconductor device manufacturing apparatus according to any of the above described fourteenth to twenty first inventions, further comprising:
lifting/lowering means for changing a height position of the substrate,
wherein the lifting/lowering means disposes the substrate at a height position where an electron density in the vicinity of the substrate is equal to or less than one twentieth of a highest electron density in the plasma.

A semiconductor device manufacturing apparatus according to a twenty third invention which solves the above described problems is the semiconductor device manufacturing apparatus according to any of the above described fourteenth to seventeenth inventions, further comprising:
thermal treatment means for performing thermal treatment to the substrate as the promoting means,
wherein in the reaction promoting step, the cross-linking reaction of the borazine skeletal molecules in the formed insulating film for the semiconductor device is promoted by the thermal treatment by the thermal treatment means.

A semiconductor device manufacturing apparatus according to a twenty fourth invention which solves the above described problems is the semiconductor device manufacturing apparatus according to any of the above described fourteenth to seventeenth inventions, further comprising:
ultraviolet ray radiation means for irradiating the substrate with ultraviolet rays as the promoting means,
wherein in the reaction promoting step, the cross-linking reaction of the borazine skeletal molecules in the formed insulating film for the semiconductor device is promoted by ultraviolet ray radiation by the ultraviolet ray radiation means.

A semiconductor device manufacturing apparatus according to a twenty fifth invention which solves the above described problems is the semiconductor device manufacturing apparatus according to any of the above described fourteenth to seventeenth inventions, further comprising:
electron beam radiation means for irradiating the substrate with an electron beam as the promoting means,
wherein in the reaction promoting step, the cross-linking reaction of the borazine skeletal molecules in the formed insulating film for the semiconductor device is promoted by electron beam radiation by the electron beam radiation means.

A semiconductor device manufacturing apparatus according to a twenty sixth invention which solves the above described problems is the semiconductor device manufacturing apparatus according to any of the above described fourteenth to seventeenth inventions, further comprising:
ion radiation means for irradiating the substrate with ions is provided; and as the promoting means,
wherein in the reaction promoting step, the cross-linking reaction of the borazine skeletal molecules in the formed insulating film for the semiconductor device is promoted by ion radiation by the ion radiation means.

An insulating film for a semiconductor device according to a twenty seventh invention which solves the above described problems, comprising:
a borazine skeletal structure, wherein,
in infrared absorption measurement of the borazine skeletal structure, a ratio [B/A] of an absorption peak intensity A at wave numbers of 1200 to 1600 cm⁻¹ and an absorption peak intensity B at wave numbers of 3000 to 3600 cm⁻¹ in the measurement is equal to or less than 0.5.

An insulating film for a semiconductor device according to a twenty eighth invention which solves the above described problems, comprising:
a borazine skeletal structure, wherein,
in laser Raman spectroscopy measurement of the borazine skeletal structure at an excitation wavelength of 413 mm using Kr laser as a light source, a ratio [D/(D+G)] is equal to or more than 0.4 and equal to or less than 0.6, wherein, in the measurement, an intensity of a spectrum peak of wave numbers of 1100 to 1400 cm⁻¹ is D, and an intensity of a spectrum peak of wave numbers of 1400 to 1700 cm⁻¹ is G.

An insulating film for a semiconductor device according to a twenty ninth invention which solves the above described problems, comprising:
a borazine skeletal structure, wherein,
in X-ray photoelectron spectroscopy measurement of the borazine skeletal structure, the positions of spectrum peaks of boron atoms, nitrogen atoms, and carbon atoms in the film are 189.0 eV to 191.0 eV, 397.0 eV to 399.0 eV, and 283.0 eV to 285.5 eV, respectively; and the rate of oxygen atoms among constituent elements of the interior of the film is equal to or less than 10%.

An insulating film for a semiconductor device according to a thirtieth invention which solves the above described problems is the insulating film for the semiconductor device according to any of the twenty seventh to twenty ninth inventions, wherein
change of permittivity of the insulating film for the semiconductor device is equal to or less than 0.1 under an environment having a temperature of 25°C and a humidity of 50%Rh.

### EFFECTS OF THE INVENTION

According to the first to twenty sixth inventions, the insulating film for the semiconductor device having the characteristics of low permittivity, low leak current, and high mechanical strength and undergoes small time-dependent change of these characteristics can be manufactured.

According to the twenty seventh to thirtieth inventions, the insulating film for the semiconductor device having the characteristics of low permittivity, low leak current, and high mechanical strength and undergoes small time-dependent change of these characteristics can be obtained, and increase in the degree of integration and speed-up of the semiconductor device can be achieved when the insulating film for the semiconductor device having such characteristics is applied to the semiconductor device.

### BRIEF DESCRIPTION OF DRAWINGS

[FIG. 1] A transparent side view explaining a semiconductor device manufacturing apparatus according to the present invention.
[FIG. 2] Adrawing explaining a manufacturing method of a semiconductor device according to the present invention.
[FIG. 3] A graph showing the electron density of plasma with respect to height positions above a substrate in the plasma CVD apparatus shown in FIG. 1.
[FIG. 4] A graph showing the correlation between the [LF power x application time] and the ○ composition rate in the reaction promoting process shown in FIG. 2.
[FIG. 5] A graph in which an insulating film for the semiconductor device according to the present invention is evaluated by using infrared absorption measurement.
[FIG. 6] A graph in which the insulating film for the semiconductor device according to the present invention is evaluated by using laser Raman spectroscopy measurement.
[FIG. 7] Graphs in which the insulating film for the semiconductor device according to the present invention is evaluated by using XPS measurement, wherein (a) shows an appropriate film formation state, and (b) shows an inappropriate film formation state.

### DESCRIPTION OF REFERENCE NUMERALS

- 1: PLASMA CVD APPARATUS
- 2: VACUUM CHAMBER
- 3: CEILING BOARD
- 4: HIGH-FREQUENCY ANTENNA
- 5: MATCHING BOX
- 6: HIGH-FREQUENCY POWER SOURCE
- 7: SUPPORTING TABLE
- 8: SUBSTRATE
- 9: LIFTING/LOWERING DEVICE
- 10: PLASMA
- 11: ELECTRODE
- 12: MATCHING BOX
- 13: LOW-FREQUENCY POWER SOURCE
- 14: GAS NOZZLE
- 15: GAS CONTROLLING DEVICE
- 16: MAIN CONTROLLING DEVICE

### BEST MODES FOR CARRYING OUT THE INVENTION

The present invention realizes an insulating film for a semiconductor device having the characteristics of low permittivity, low leak current, and high mechanical strength and, in addition to that, further realizes the insulating film for the semiconductor device in which time-dependent change of the characteristics of the low permittivity, low leak current, and high mechanical strength is small by arranging processes.

In more detail, a borazine skeleton structure film, which is the insulating film for the semiconductor device, is formed by using a plasma CVD apparatus and using borazine skeletal molecules shown in a chemical formula (1), which is described later, as a raw material; as the characteristics thereof, low permittivity (specific permittivity: 3.5 or less), a low leak current (leak current: 5E-8A/cm²@2MV/cm or less), and high mechanical strength (Young's modulus: 10 GPa or more) are realized; and, stability of the specific permittivity (time-dependent change in the specific permittivity: 0.1 or less) is realized as stability of the characteristics.

Hereinafter, the insulating film for the semiconductor device, a manufacturing apparatus of the same, and a manufacturing method of the semiconductor device using the insulating film for the semiconductor device according to the present invention will be explained in detain.

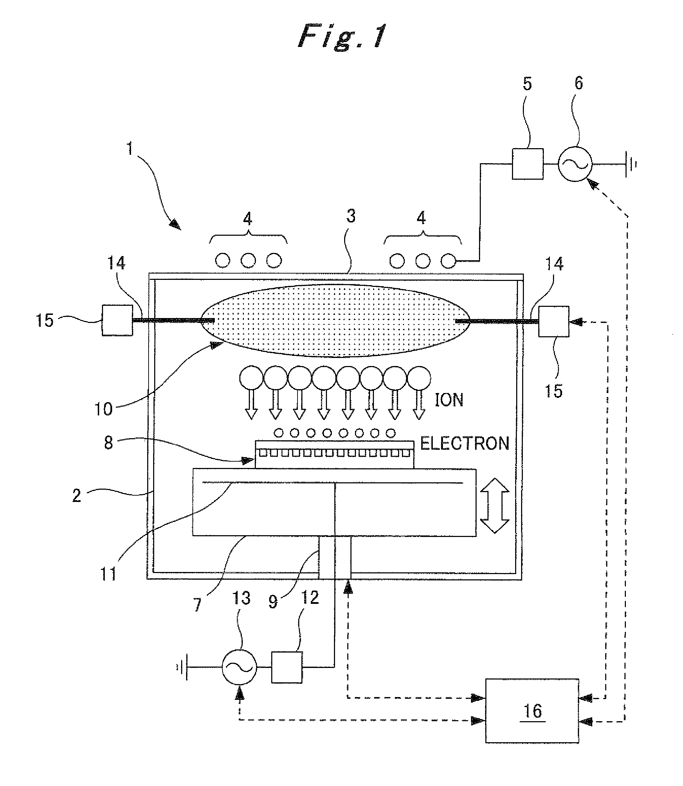

FIG. 1 is a transparent side view explaining the semiconductor device manufacturing apparatus according to the present invention.
Note that, in FIG. 1, a plasma CVD apparatus 1 of a TCP (Transfer Coupled Plasma) type is shown as an example; however, the manufacturing method of the semiconductor device according to the present invention, which will be described later, can be carried out by another plasma CVD apparatus such as that of an ICP (Inductively Coupled Plasma) type. However, in the later-described case in which (B1d) the substrate position is controlled, carrying out the method by a plasma CVD apparatus of a parallel plate type is not desirable.

In the plasma CVD apparatus 1 of the insulating film for the semiconductor device according to the present invention, the interior of a cylindrical vacuum chamber 2 is formed as a film forming chamber, and a circular-plate-like ceiling board 3 made of ceramic is disposed at an opening of an upper part of the vacuum chamber 2 so as to close the opening.

Moreover, high-frequency antennas 4 comprising, for example, a plurality of circular rings are disposed above the ceiling board 3, and a high-frequency power source 6 is connected to the high-frequency antennas 4 via a matching box 5 (plasma generating means). The high-frequency power source 6 is capable of supplying power of an oscillation frequency (for example, 13.56 MHz) higher than that of a low-frequency power source 13, which will be described later, to the high-frequency antennas 4, and electromagnetic waves which generate plasma in the vacuum chamber 2 can be injected thereto by permeation through the ceiling board 3.

Moreover, a supporting table 7 is provided in a lower part of the vacuum chamber 2 so that a substrate 8 of, for example, semiconductor is electrostatically sucked and held onto an upper surface of the supporting table 7 by, for example, an electrostatic chuck. The position of the supporting table 7 can be vertically lifted and lowered by a lifting/lowering device 9 (lifting/lowering means), so that the distance between plasma 10, which is generated in the vacuum chamber 2 upon film formation, and the substrate 8 can be adjusted. Moreover, an electrode part 11 is provided in the supporting table 7, and the low-frequency power source 13 (bias applyingmeans) is connected to the electrode part 11 via a matching box 12. The low-frequency power source 13 is capable of applying an oscillation frequency (for example, 4 MHz) lower than that of the high-frequency power source 6 to the electrode part 11 and applying a bias to the substrate 8. Moreover, the supporting table 7 is provided with a temperature controlling device (for example, a heater or a cooling medium channel; illustration omitted) which controls the temperature of the substrate 8, and the substrate 8 can be set to a desired temperature (for example, 100 to 500°C) by the temperature controlling device.

Moreover, at sidewall portions of the vacuum chamber 2, a plurality of gas nozzles 14 are provided at the positions lower than the ceiling board 3 and higher than the supporting table 7 and controlled by gas controlling devices 15 so as to supply a gas from the gas nozzles 14 into the vacuum chamber 2 at a desired flow rate (gas supplying means). As the supplied gas, borazine skeletal molecules shown in a below chemical formula (1) and a carrier gas are used. The borazine skeletal molecules are liquid at ordinary temperatures and pressures; therefore, the borazine skeletal molecules are gasified and then supplied to the vacuum chamber 2 by using an inert gas as the carrier gas. Generally, a rare gas such as helium or argon or nitrogen is used as the carrier gas; however, a mixed gas thereof or a mixed gas to which hydrogen, oxygen, ammonia, methane, etc. is added in accordance with needs may be used.

The borazine skeletal molecules correspond to those having the below chemical formula. 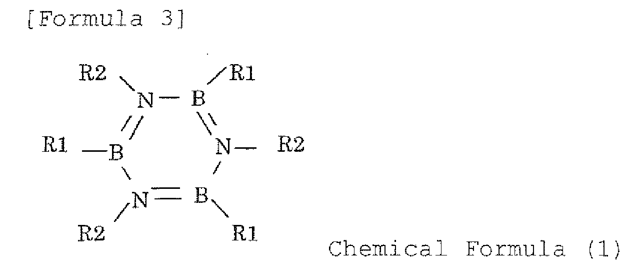 Herein, each of R1 and R2 in the above described chemical formula (1) is a hydrogen atom or an alkyl group, alkenyl group, a monoalkylamino group, or a dialkylamino group having a carbon number of 5 or less, and R1 and R2 may be the same or different from each other. However, the cases in which all of R1 and R2 are hydrogen atoms are excluded.

Moreover, a pressure controlling device (for example, a vacuum pump; illustration omitted) is connected to the vacuum chamber 2, and the pressure of the interior of the vacuum chamber 2 can be adjusted to a desired pressure by the pressure controlling device.

The above described high-frequency power source 6, the lifting/lowering device 9, the low-frequency power source 13, the gas controlling device 15, the temperature controlling device, the pressure controlling device, etc. are controlled by a main controlling device 16 (control means) in an integrated manner and are controlled in accordance with desired process steps and process conditions set in advance.

Next, the manufacturing method of the semiconductor device according to the present invention carried out in the plasma CVD apparatus 1 will be explained in detail.

### <A. Process Steps>

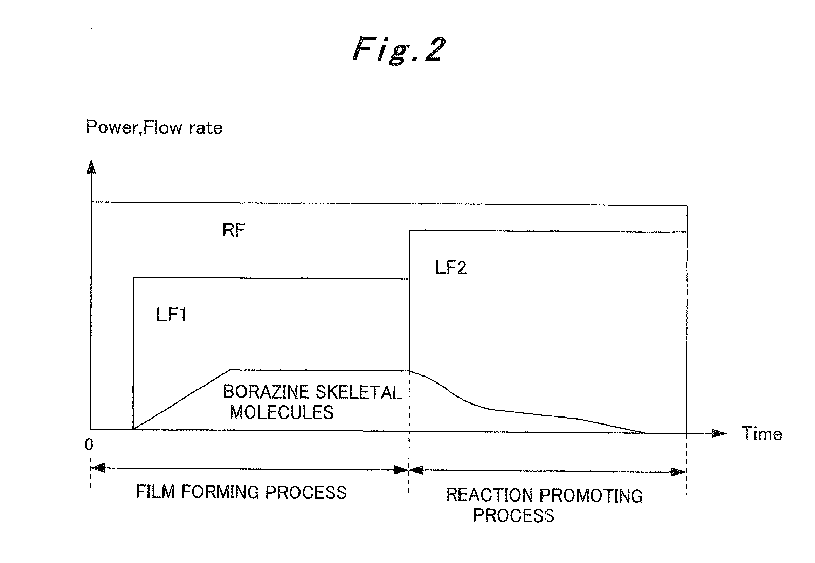

As shown in FIG. 2, the manufacturing method of the semiconductor device according to the present invention comprises two stages of process steps, i.e., a film forming process and a reaction promoting process.

### (A1) Film Forming Process

The film forming process is a process for disassociating R1 and R2 of the side chain groups of the borazine skeletal molecules and subjecting the molecules to gas-phase polymerization with one another without breaking the borazine skeleton structures (6-membered ring structures) of the borazine skeletal molecule raw material; and, in order to carry out this process, the electric power LF1 applied from the low-frequency power source 13 is caused to be lower than the electric power LF2 of the reaction promoting process. Moreover, the electric power RF applied from the high-frequency power source 6 forms the plasma state merely with the inert gas at the beginning of the process in order to stabilize the plasma; and, after it is stabilized, the electric power LF1 is applied from the low-frequency power source 13, and the borazine skeletal molecules and the inert gas are gradually increased to a desired flowrate. At this time, the borazine skeletal molecules undergo gas-phase polymerization without breaking the skeletons thereof, and a film thereof is formed on the substrate 8. Through this process, a thin film having the borazine skeleton structure is formed, and basic characteristics of the borazine skeleton structure film, specifically, the characteristics of permittivity reduction, low leak current, and high mechanical strength are established. Then, when the film forming process of predetermined time is finished, the process proceeds to the reaction promoting process.

### (A2) Reaction Promoting Process

The reaction promoting process is a process for promoting the cross-linking reaction of the borazine skeletal molecules in the thin film formed on the substrate 8, and, for example, plasma treatment, thermal treatment, ultraviolet ray radiation treatment, electron beam radiation treatment, or ion radiation treatment is affective.
When the plasma treatment is to be carried out as promoting means of the cross-linking reaction of the borazine skeletal molecules in the thin film formed on the substrate 8, the electric power LF2 applied from the low-frequency power source 13 is caused to be larger than the electric power LF1 of the film forming process in the above describedplasma CVD apparatus 1. Moreover, since film formation is not required, the borazine skeletal molecules are gradually reduced, and the treatment of the formed thin film is carried out by mainly using the plasma of a carrier gas. Herein, the carrier gas used in the reaction promoting process is particularly desirably the gas of a rare gas (for example, He, Ar) or N₂ in order to eliminate the reaction with the thin film per se.

When the thermal treatment is to be carried out, a thermal treatment means, which heats the substrate 8, is provided in the plasma CVD apparatus 1 as a promoting means of the cross-linking reaction; and the thermal treatment is carried out at a temperature of 100°C or higher and 500°C or lower in a gas which is not reacted with the thin film per se, thereby generating the cross-linking reaction promoting effect of the borazine skeletal molecules in the thin film formed on the substrate 8. As the thermal treatment means, for example, the temperature controlling device provided in the supporting table 7 may be used.
Meanwhile, when the ultraviolet ray radiation treatment is to be carried out, an ultraviolet ray radiating means, which irradiates the substrate 8 with ultraviolet rays, is provided in the plasma CVD apparatus 1 as a promoting means of the cross-linking reaction; and ultraviolet rays having a wavelength of 400 nm or less are radiated in a gas which is not reacted with the thin film per se, thereby generating the cross-linking reaction promoting effect of the borazine skeletal molecules in the thin film formed on the substrate 8.
Meanwhile, when the electron ray radiation treatment is to be carried out, an electron beam radiating means, which irradiates the substrate 8 with electron beams, is provided in the plasma CVD apparatus 1 as the promoting means of the cross-linking reaction; and electron beams are radiated in a gas which is not reacted with the thin film per se, thereby generating the cross-linking reaction promoting effect of the borazine skeletal molecules in the thin film formed on the substrate 8.
Meanwhile, when the ion radiation treatment is to be carried out, an ion radiating means, which irradiates the substrate 8 with ions, is provided in the plasma CVD apparatus 1 as a promoting means of the cross-linking reaction; and ions are radiated in a gas which is not reacted with the thin film per se, thereby generating the cross-linking reaction promoting effect of the borazine skeletal molecules in the thin film formed on the substrate 8.

This reaction promoting process promotes the cross-linking reaction by condensing the reaction active groups remaining in the thin film of the borazine skeleton structure formed in the film forming process and removes B-H bonds. Therefore, permittivity reduction is further promoted by the promotion of the cross-linking reaction, time-dependent change is suppressed by removal of the B-H bonds which serve as the active sites of reaction with moisture, and stability is improved. Moreover, further higher mechanical strength is obtained (mechanical strength, Young's modulus: 10 GPa or more) by the promotion of the cross-linking reaction; and, as a result, chemical resistance is improved, processability is improved, and CMP (Chemical Mechanical Polish) resistance is improved. Note that heat resistance can be achieved since an inorganic polymer based material having excellent heat resistance compared with organic based polymer materials is used.

Particularly, the effect brought about by the reaction promoting process is notable. Even when the conditions of the film forming process are the same in the case in which the reaction promoting process is not carried out, permittivity largely increases from an initial value along with date and hours, and, after seven days have passed, the permittivity is increased to about 1.4 times the initial value. On the other hand, when the reaction promoting process is carried out, even after two weeks have passed, the permittivity is almost the same as the initial value thereof, and it can be found out that the time-dependent change can be suppressed. Note that stability of the specific permittivity is confirmed by allowing it to stand in an environment having a temperature of 25°C and a humidity of 50%Rh and evaluating it.

### <B. Process Conditions>

Subsequently, preferred process conditions in the manufacturing method of the semiconductor device according to the present invention will be explained. Herein, the process conditions preferred for the process steps of the above described (A1) film forming process and (A2) reaction promoting process will be explained.

The insulating film for the semiconductor device according to the present invention realizes, at least, the characteristics such as permittivity reduction, a low leak current, high mechanical strength, and stability. Therefore, preferred process conditions are defined from the viewpoint of the permittivity reduction, low leak current, high mechanical strength, stability, etc. Specifically, the preferred process conditions are defined so that, as the conditions, specific permittivity is 3.5 or less as the reduced permittivity, the leak current is 5E-8A/cm²@2MV/cm or less as the low leak current, and a specific permittivity variation is 0.1 or less as the stability of the characteristics. Hereinafter, the preferred conditions are shown for each process step and each process condition.

### (B1) Film Forming Process

The film forming process is a process relating to basic characteristics of the insulating film for the semiconductor device according to the present invention, and preferred process conditions are defined on the condition that the specific permittivity is equal to or less than 3.5, and the leak current is equal to or less than 5E-8A/cm²@2MV/cm as the low leak current.

### (B1a) LF Power

In the film forming process, as described above, it is important to disassociate R1 and R2 of the side chain groups of the borazine skeletal molecules without breaking the borazine skeleton structure and to subject the molecules to gas-phase polymerization with one another. Therefore, when the correlation between the LF power and the specific permittivity and the leak current was checked, the specific permittivity had a tendency that the specific permittivity increased little by little along with increase of the LF power. The leak current also has a tendency that the leak current increases along with increase of the LF power; however, when the LF power was larger than 3180 W/m², the leak current became larger than 5E-8A/cm²@2MV/cm. Conceivably, this was for the reason that, when the LF power was excessively high, the probability that the borazine skeleton structure was broken increased, and, as a result, conversion of the gas-phase-polymerized borazine skeletal molecules to graphite progressed, which adversely affected the specific permittivity and, particularly, the characteristic of the leak current. Therefore, the LF power in the film forming process is desirably equal to or less than 3180 W/m², when converted to the power per unit area.

### (B1b) Substrate Temperature

Next, when the correlation between the substrate temperature and the specific permittivity and the leak current was checked, the specific permittivity had a tendency that the specific permittivity increased along with increase of the temperature and, when the temperature exceeded 300°C, the specific permittivity was saturated and had a constant value, which was equal to or less than 3.5 at any temperature. Meanwhile, the leak current had a tendency that the leak current had a constant value regardless of the increase of the temperature, and the leak current was equal to or less than 5E-8A/cm²@2MV/cm at any temperature. Therefore, it can be understood that the specific permittivity and the leak current are not affected by the substrate temperature. Therefore, the substrate temperature in the film forming process can be set so that the vaporization temperature of the raw material gas is a lower limit and the heat resistance temperature of the material used in the vacuum chamber 2 is an upper limit, for example, the temperature may be 150°C to 450°C or less. Note that the condition of the substrate temperature may be the same condition or may be different in the below described reaction promoting process.

### (B1c) RF Power

Next, when the correlation between the RF power and the specific permittivity and the leak current was checked, the specific permittivity has a tendency that the specific permittivity, increases along with increase of the RF power, and the specific permittivity, was larger than 3.5 when the RF power exceeded 127400 W/m². Meanwhile, the leak current also has a tendency that the leak current increases along with increase of the RF power; however, the leak current was equal to or less than 5E-8A/cm²@2MV/cm at any RF power. As well as the LF power, conceivably, this was for the reason that, when the RF power was excessively high, the probability that the borazine skeleton structure was broken increased, and, as a result, conversion of the gas-phase-polymerized borazine skeletal molecules to graphite progressed, which adversely affected the leak current and, particularly, the characteristic of the specific permittivity. Therefore, the RF power in the film forming process is desirably equal to or less than 127400 W/m². Meanwhile, regarding the lower limit side of the RFpower, there is a tendency that the lower the RF power, the better the specific permittivity and the leak current; however, when to stably ignite the plasma is taken into consideration, 1590 W/m² or more is desirable as the lower limit value thereof. As described above, the RF power in the film forming process is desirably equal to or more than 1590 W/m² and equal to or less than 127400 W/m² when converted to the power per unit area. Note that the condition of the RF power may be the same condition or may be different in the below-described reaction promoting process.

### (B1d) Substrate Position

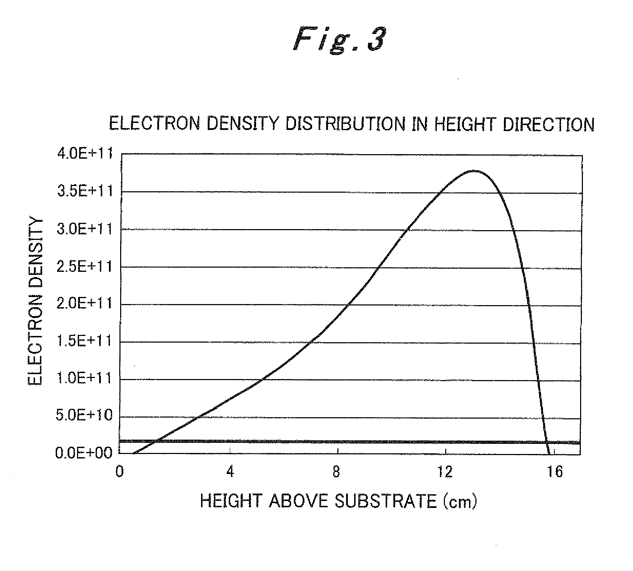

Note that, a height position of the substrate 8 is desirably the position where the electron density in the vicinity of the substrate 8 is equal to or less than one twentieth of the highest electron density in the plasma 10. For example, in the plasma CVD apparatus 1 shown in FIG. 1, when the substrate 8 is disposed at a position away from the position where the electron density in the plasma 10 is the highest (plasma density center) by 10 cm or more as shown in FIG. 3, the electron density thereof becomes one twentieth or less of the plasma density center. Therefore, the height position of the substrate 8 (supporting table 7) is adjusted to the position where the electron density is one twentieth or less by using the lifting/lowering device 9. When the height position of the substrate 8 is adjusted in this manner, the influence of the plasma 10 can be reduced, and low-temperature film formation at, for example, 300°C or less can be carried out. Meanwhile, when the position of the supporting table 7 is fixed, the height position of the high-frequency antennas 4 (ceiling board 3) may be adjusted so that the electron density in the vicinity of the substrate 8 is equal to or less than one twentieth of the highest electron density in the plasma 10. Note that the below-described reaction promoting process also uses the same condition as the condition of the substrate position.

### (B2) Reaction Promoting Process

The reaction promoting process is a process relating to the stability of the characteristics of the insulating film for the semiconductor device according to the present invention, and preferred process conditions are defined on the condition that the specific permittivity variation is equal to or less than 0.1 as the stability of the specific permittivity. Note that the process conditions of the case in which the plasma treatment is used as an example are shown herein.

### (B2a) LF Power × Time

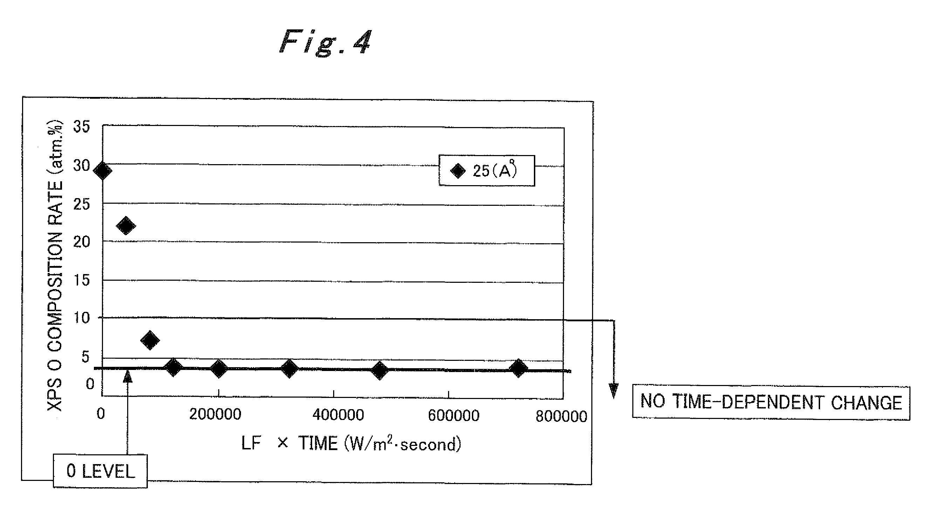

In the reaction promoting process, as described above, it is important to promote polymerization between reaction-active residues contained in the thin film of the borazine skeleton structure, which has undergone gas-phase polymerization in the film forming process, and promote the cross-linking reaction. Therefore, the correlation between the [LF power × application time] and the composition rate of O (oxygen) in the thin film was checked by using XPS (X-ray Photoelectron Spectroscopy), and the results as shown in FIG. 4 were obtained. Note that the measurement of the O composition rate by XPS is utilized as an index to measure the degree of time-dependent change. Herein, the O composition rate of the interior of the film having a depth of equal to or more than 25 A from the surface of the film is measured.

As shown in FIG. 4, the O composition rate in the film had a tendency that the O composition rate is rapidly reduced along with increase of the [LF power × application time] and reduced to an approximately constant level (about 3 atm. %) after 95550 W/m². According to findings in the past, it is known that moisture absorption readily occurs when the amount of oxygen in the film is large, and that, as a result, the characteristics undergo time-dependent change; and it is known that the time-dependent change can be suppressed when the ○ composition rate in the film is suppressed to 10 atm.% or less. Meanwhile, the O composition rate of about 3 atm. % is detected when background is measured; therefore, when the measured O composition rate is about 3 atm.%, it can be estimated that the O composition rate in the film is practically approximately 0. According to these facts, it was found out that applying the reaction promoting process notably contributes to stability of the characteristics of the thin film. Therefore, the [LF power × application time] in the reaction promoting process is desired to be equal to 95550 W/m².second or more.

### (B2b) LF Power

When the time-dependent change of the dielectric constant in the cases in which the LF power is 1590 W/m², 3180 W/m², and 15900 W/m² is evaluated in order to check the correlation between the LF power and the stability of the characteristics of the thin film (time-dependent change of the specific permittivity), the specific permittivity rapidly increases in several days in the case of 1590 W/m²; on the other hand, in the cases of 3180 W/m² and 15900 W/m², the specific permittivity is approximately constant, and the difference therebetween is apparent. Therefore, when the LF power in the reaction promoting process is desirably 3180 W/m² or more when converted to the power per unit area. Note that, when the LF power is too large, the thin film is damaged due to sputtering effects; therefore, the upper limit of the LF power is desirably 127400 W/m² or less.

### (B2c) RF Power

Next, when the correlation between the RF power and the specific permittivity, and the leak current is checked, different from the tendency of the RF power in the film forming process, both the specific permittivity and the leak current are not largely affected by the value of the RF power. On the other hand, there is a tendency that the higher the RF power, the more the film quality stability is improved. Therefore, in the reaction promoting process, higher RF power is preferred; however, there is a tendency that mechanical strength is notably reduced. when the RF power is over 127400 W/m². When these are taken into consideration, the RF power in the reaction promoting process is desirably equal to or less than 127400 W/m². Meanwhile, regarding the lower limit side of the RF power, when stable ignition of the plasma is taken into consideration, equal to or more than 1590 W/m² is desirable as the lower limit value thereof. As described above, the RF power in the reaction promoting process is desirably equal to or more than 1590 W/m² and equal to or less than 127400 W/m².

An example of a preferred embodiment of the manufacturing method of the semiconductor device according to the present invention using the above described process steps and process conditions will be described below.

### (Step 1)

The substrate 8 is conveyed into the vacuum chamber 2 by using a conveyance device, which is not shown, and is placed on the supporting table 7, and the substrate 8 is sucked and held by an electrostatic chuck. The supporting table 7 is controlled to a temperature of 500°C or less in advance, desirably, to a temperature of 130°C to 400°C by the temperature controlling device, so that the temperature of the substrate 8 canbeprocessed at a desired set temperature by controlling the temperature of the supporting table 7 (see above described (B1b)). Meanwhile, the height position of the supportingtable 7 is moved to aposition that is away from the plasma density center by 10 cm or more by the lifting/lowering device 9 (see above described (B1d) and FIG. 3).

### (Step 2)

A He gas is supplied into the vacuum chamber 2 from the gas nozzles 14 by using gas controlling means 15, the degree of vacuum in the vacuum chamber 2 is controlled to about 20 mTorr by a vacuum controlling device, and the RF power having a frequency of 13.56 MHz is supplied from the high-frequency power source 6 to the high-frequency antennas 4 via the matching box 5, so as to cause electromagnetic waves to enter the vacuum chamber 2 and generate the plasma 10 in the vacuum chamber 2. The RF power supplied by the high-frequency power source 6 is controlled by the electric power within the range of 1590 W/m² to 127400 W/m² until the series of processes is finished (see above described (B1c)). Note that the flow rate of the carrier gas supplied from the gas nozzles 14 is controlled to an appropriate flow rate until the series of processes is finished, and the flow rate is desirably about 200 sccm to 1000 sccm.

### (Step 3)

After the plasma 10 is stabilized, the LF power having a frequency of 4 MHz is supplied from the low-frequency power source 13 to the electrode 11 via the matching box 12, and the gasified borazine skeletal molecules are supplied into the vacuum chamber 2 from the gas nozzles 14 while gradually increasing the amount thereof to a predetermined amount, and the degree of vacuum in the vacuum chamber 2 is controlled to about 20 mTorr. The LF power supplied by the low-frequency power source 13 is controlled to the electric power that is 3180 N/m² or less in the film forming process (see above described (B1a)). Then, under the above described process conditions, the film forming reaction in the film forming step is carried out, in other words, the borazine skeletal molecules in the plasma state undergo gas-phase polymerization with one another and are adsorbed onto the substrate 8, thereby carrying out the film forming reaction in which a desirable borazine skeleton structure film is formed.

### (Step 4)

The film forming process step is carried out for predetermined time; and, when a thin film having a desirable film thickness is formed on the substrate 8, the film forming process step is finished, and the reaction promoting process step is subsequently carried out.
When the present step is to be carried out by the plasma, the LF po wer supplied to the electrode 11 from the low-frequency power source 13 is caused to have magnitude different from that of the LF power of the film forming reaction process step, the borazine skeletal molecules supplied from the gas nozzles 14 into the vacuum chamber 2 are supplied while gradually reducing the amount thereof, and the degree of vacuum in the vacuum chamber 2 is controlled to about 10 to 50 mTorr. In the reaction promoting process, the [LF power × application time] applied by the low-frequency power source 13 is equal to or more than 3000 W·second (95550 W/m²·second), and the LF power is controlled under the condition that the LF power is equal to or more than 3180 W/m² or the application time is equal to or more than 35 seconds (see above described (B2a) to (B2b) and FIG. 4). Then, under the above described process conditions, the reaction promotion in the reaction promoting process step is carried out, in other words, the cross-linking reaction mutually between the borazine skeletal molecules is promoted.

Note that, when the present step is to be carried out by the thermal treatment, the thermal treatment is carried out at a temperature equal to or more than 100°C and equal to or less than 500°C in the gas that is not reacted with the thin film per se.
Meanwhile, when the present step is to be carried out by the ultraviolet ray radiation treatment, ultraviolet rays having a wavelength of 400 nm or less is radiated in the gas that is not reacted with the thin film per se.
Meanwhile, when the present step is to be carried out by the electron beam radiation treatment, an electron beam is radiated in the gas that is not reacted with the thin film per se.
Meanwhile, when the present step is to be carried out by the ion radiation treatment, ions are radiated in the gas that is not reacted with the thin film per se.
In addition, these treatments may be carried out in combination in the present step.
Furthermore, the film formingprocess step and the reaction promoting process step may be processed in the same apparatus or may be processed in different apparatuses provided with a vacuum conveyance system.

### <C. Characteristics of the Insulating Film for the Semiconductor Device According to the Present Invention>

The insulating film for the semiconductor device according to the present invention formed by using the above described process steps and the process conditions has the characteristics of reduced permittivity (specific permittivity,: 3.5 or less) and a reduced leak current (leak current: 5E-8A/cm²@2MV/cm or less) and has the characteristics described below. In the insulating film for the semiconductor device according to the present invention, the side chain groups of the borazine skeletal molecules are disassociated by the plasma, and cross-linking is promoted by the polymerization reaction of the reaction active species of the radicals and ions generated by the disassociation; therefore, the results of the below-described various qualitative analyses with respect to the insulating film for the semiconductor device according to the present invention have a tendency that they are not largely affected by the differences of the disassociated substitution groups of the side chains of the borazine rings. Therefore, the characteristics shown below serve as indexes for estimating (evaluating) stability of the characteristics, particularly, stability of the specific permittivity.

### (C1) Infrared Absorption Measurement

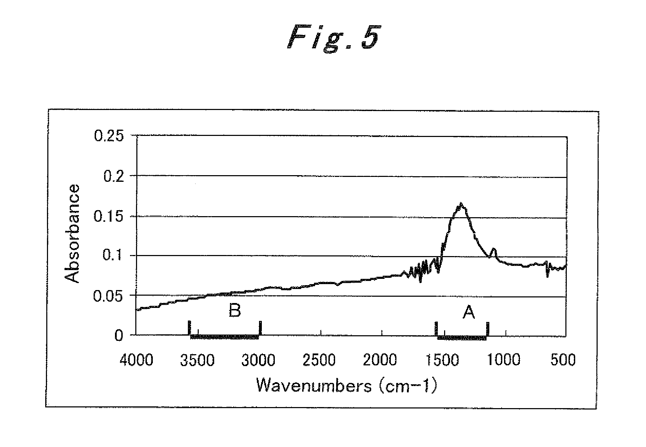

Infrared absorption measurement can measure the information of functional groups, quality of compounds, etc. When the insulating film for the semiconductor device manufactured by the present invention is evaluated by using infrared absorption measurement, as shown in PIG. 5, a large absorption peak corresponding to B-N bonds is observed in the region of wave numbers of 1200 to 1600 cm⁻¹, and an absorption peak corresponding to O-H bonds is observed in the region of wave numbers of 3000 to 3600 cm⁻¹. Furthermore, the absorption peak intensity in the region of the wave numbers of 1200 to 1600 cm⁻¹ corresponding to the B-N bonds is assumed to be A, and the absorption peak intensity in the region of the wave numbers of 3000 to 3600 cm⁻¹ corresponding to the O-H bonds is assumed to be B; in this case, the insulating film for the semiconductor device manufactured by the present invention can be confirmed to have the characteristic that the ratio [B/A] is equal to or less than 0.5 (see FIG. 5). The ratio [B/A] can be defined to be corresponding to the moisture absorption rate of the film. When the ratio [B/A] is small, in other words, when the amount of O-H bonds is small, the moisture absorption rate is lowered, and, as a result, time-dependent change is not caused. In other words, a relatively small amount of O-H bonds is good for time-dependent stability of the specific permittivity; and it was confirmed that, when the ratio [B/A] is equal to or less than 0.5, time-dependent change does not occur in the insulating film for the semiconductor device manufactured by the present invention. In this manner, the ratio [B/A] serves as an index for estimating (evaluating) the time-dependent stability of the specific permittivity.

### (C2) Laser Raman Spectroscopy Measurement

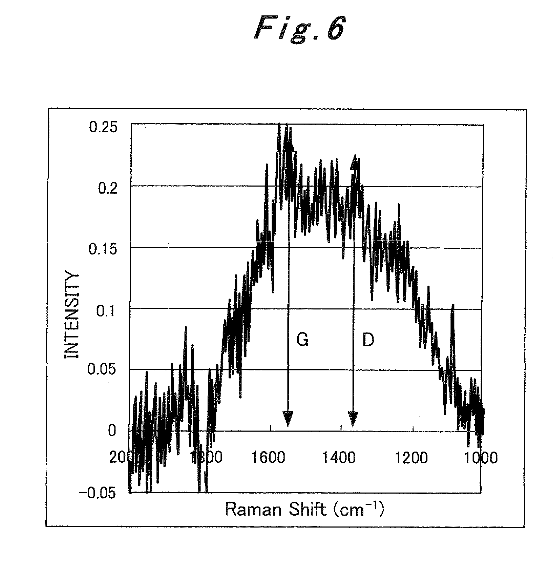

Laser Raman spectroscopy measurement can measure the bonding state of molecules, etc. When the insulating film for the semiconductor device manufactured by the present invention is evaluated by using laser Raman spectroscopy measurement at an excitation wavelength of 413 nm using Kr laser as a light source, as shown in FIG. 6, a spectrum peak based on sp3 bonds is observed in the region of wave numbers of 1100 to 1400 cm⁻¹, and a spectrum peak based on sp2 bonds is observed in the region of wave numbers of 1400 to 1700 cm⁻¹. Furthermore, the intensity of the spectrum peak in the region of the wave numbers of 1100 to 1400 cm⁻¹ based on the sp3 bonds is assumed to be D, and the intensity of the spectrum peak in the region of the wave numbers of 1400 to 1700 cm⁻¹ based on the sp2 bonds is assumed to be G; in this case, in the insulating film for the semiconductor device manufactured by the present invention, it can be confirmed that the ratio [D/ (D+G)] is equal to or more than 0.4 and equal to or less than 0.6 (see FIG. 6).

The intensity D is the peak based on the sp3 bonds. The intensity D being high means that the cross-linking density is high, in other words, the mechanical strength is high. Meanwhile, the strength G is the peak based on the sp2 bonds and relates to graphite structures . The strength G being high means that the amount of graphite components, which lead to increase in the permittivity and leak current, is large. Therefore, in order to increase the cross-linking density and to reduce the graphite structures of carbon, which lead to increase in the permittivity, and leak current, without breaking the benzene ring structure of BN, the G component rate has to be lowered while increasing the D component rate. From the viewpoint to achieve both mechanical strength and film stability, it was confirmed that the insulating film for the semiconductor device manufactured by the present invention has the characteristics of high mechanical strength and low permittivity/low leak current in combination when the ratio [D/ (D+G)] is equal to or more than 0.4 and equal to or less than 0.6. In this manner, the ratio [D/ (D+G)] serves as an index for estimating (evaluating) the high mechanical strength and the low permittivity/low leak current.

### (C3) XPS Measurement

XPS measurement can measure bonding energy of elements, etc. When the insulating film for the semiconductor device manufactured by the present invention is evaluated by using the XPS measurement, at the interior of the film that is 25 Å or more from the surface of the film, the position of the spectrum peak of boron atoms originates in B-N bonds and is observed in the region of 189.0 eV to 191.0 eV, the position of the spectrum peak of nitrogen atoms originates in N-B bonds and is observed in the region of 397.0 eV to 399.0 eV, and the position of the spectrum peak of carbon atoms originates in C-B bonds and is observed in the region of 283.0 eV to 285.5 eV. It was confirmed that an amorphous structure retaining the borazine skeletons was formed when the spectrum peaks of the elements were within the above described ranges.

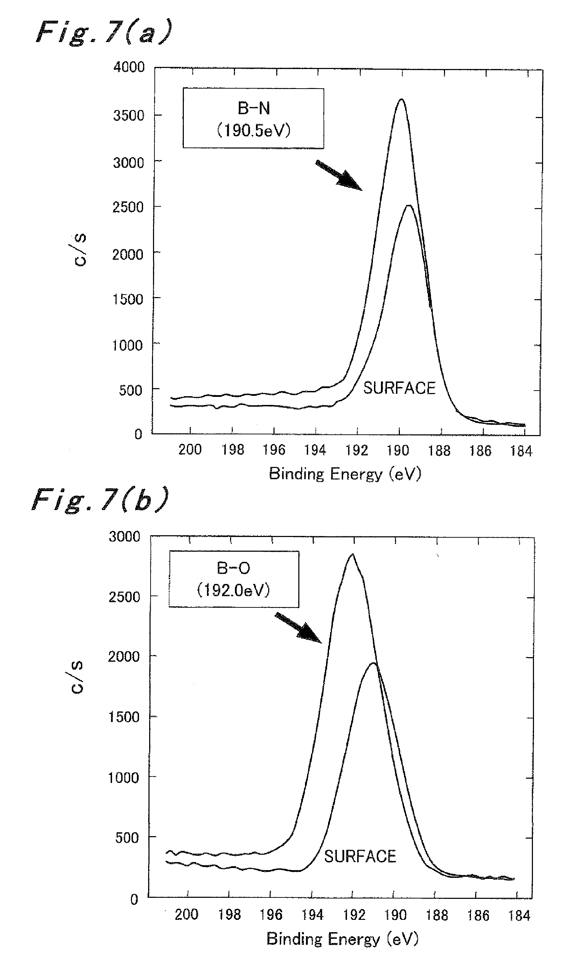

It was also confirmed that, reversely, the spectrum peaks of the elements fell outside the above described ranges when the rate of oxygen atoms was equal to or more than 10 atm.% at the interior of the film that was 25 Å or more from the film surface. For example, the position of the spectrum peak of boron atoms originates in the B-N bonds and is observed in the region of 189.0 eV to 191.0 eV in the insulating film for the semiconductor device manufactured by the present invention. As an example, as shown in FIG. 7A, it is observed in the vicinity of 190.5 eV, and the film formation state can be determined to be appropriate in such a case. However, when the rate of oxygen atoms in the film is equal to or more than 10 atm.%, the B-O bonds increase; and, originating in the B-O bonds, the position of the spectrum peak of the boron atoms shifts to the vicinity of 192 eV as shown in FIG. 7B, and the film formation state can be determined to be inappropriate in such a case. This is for the reason that the position of the spectrum peak of the object element shifts depending on the bonding energy of another element that bonds with the obj ect element. Thus, as long as the spectrum peaks of the constituent elements are within the above described ranges, it can be confirmed that the amorphous structure retaining the borazine skeletons is formed in the insulating film for the semiconductor device manufactured by the present invention and that the rate of the oxygen atoms in the film is equal to or less than 10 atm.%. In addition, the amount of the oxygen atoms in the film is desired to be small for stability of the specific permittivity; and, in the insulating film for the semiconductor device manufactured by the present invention, the fact that the spectrum peaks of the constituent elements are within the above described ranges and the fact that the rate of the oxygen atoms in the film is equal to or less than 10 atm.% serve as indexes for estimating (evaluating) the time-dependent stability of the specific permittivity.

Therefore, the insulating film for the semiconductor device according to the present invention having the above described characteristics (C1) to (C3) has the characteristics of low permittivity, low leak current, and high mechanical strength; and, since time-dependent change of these characteristics is small, when the insulating film is used in a semiconductor device, for example, as an interlayer insulating film in a semiconductor device such as a CPU, RAM, or ASIC, increase in the degree of integration and speed-up of the semiconductor device can be realized.

### <D. Examples and Comparative Examples>

Table 1 shows Examples 1 to 15 of the present invention and Comparative Examples 1 to 3.

### (Examples 1 to 15)

In Examples 1 to 15, the borazine skeleton molecules shown in the raw material fields of Table were used, a film was formed on a substrate under the film formation conditions shown in Table 1, and characteristics of the formed film were measured; and the results thereof are shown together in Table 1.
According to the results of Examples 1 to 15 in Table 1, it was found out that, in any of the cases, the formed film was excellent in bonding strength and exhibited low permittivity, highmechanical strength, and long-period stability of the above describe characteristics. Note that, as the substrate position, the substrate 8 was disposed at the position away from the position where the electron density in the plasma was the highest (plasma density center) by 10 cm. The time of the film forming step was set so that the formed film thickness became 2000 Å to 3000 Å.

### (Comparative Example 1)

In Comparative Example 1, a gas of borazine skeleton molecules comprising R1=R2=H was used as a raw material gas, a film was formed on the substrate under the film formation conditions same as Example 6 shown in Table 1, the characteristics of the formed film were measured; and the results thereof are shown together in Table 1.
According to the results of Comparative Example 1 of Table 1, it can be understood that the low permittivity property and mechanical characteristic are bad from an early period of film formation and that the above described both characteristics are further deteriorated after two weeks have past in a clean room atmosphere (23°C, relative humidity: 50%). This is for the reason that, compared with the molecules as shown in Examples 1 to 15 having organic groups at side chains, the borazine skeleton molecules comprising R1=R2=H cannot readily form active species of radicals and ions in the plasma, and the cross-linking reaction is not sufficiently promoted in the plasma in the film forming step and the reaction promoting step. Therefore, conceivably, many B-H bonds, which were highly reactive, remained even after film formation, the moisture absorption rate of the film per se was therefore high, film deterioration due to moisture absorption occurred immediately after it was taken out from the chamber, and the film characteristics and film stability were deteriorated.

### (Comparative Example 2)

In Comparative Example 2, a film was formed on the substrate under the film formation conditions of Example 6 shown in Table 1 from which the reaction promoting step was eliminated, and the characteristics of the formed film were measured; and the results thereof are shown together in Table 1.
According to the results of Comparative Example 2 of Table 1, the low permittivity property and mechanical characteristic are bad from an early period of film formation, and the above described both characteristics are further deteriorated after two weeks have past in a clean room atmosphere (23°C, relative humidity: 50%). This is conceivably for the reason that, since the film was formed under the conditions in which the reaction promoting step was not carried out, many highly reactive active sites, which had not undergone cross linking, remained after film formation, the moisture absorption rate of the film per se was therefore high, film deterioration due to moisture absorption occurred immediately after it was taken out from the chamber, and the film characteristics and film stability were deteriorated.

### (Comparative Example 3)

In Comparative Example 3, a film was formed on the substrate under the film formation conditions of Example 6 shown in Table 1 wherein the LF power of the reaction promoting step was changed to 1430 W/m², and the characteristics of the formed film were measured; and the results thereof are shown together in Table 1.
According to the results of Comparative Example 3 of Table 1, the low permittivity property and mechanical characteristic are bad from an early period of film formation, and the above described both characteristics are further deteriorated after two weeks have past in a clean room atmosphere (23°C, relative humidity: 50%). This is conceivably for the reason that, since the power of the bias applied in the reaction promoting step was not sufficient under the condition, many highly reactive active sites, which had not undergone cross linking, remained after film formation, the moisture absorption rate of the film per se was therefore high, film deterioration due to moisture absorption occurred immediately after it was taken out from the chamber, and the film characteristics and film stability deteriorated.

**[Table 1-1]**

| | | Example 1 | Example 2 | Example 3 | Example 4 | Example 5 | Example 6 |
|---|---|---|---|---|---|---|---|
| Film Forming Step | Raw Material | R1=C₂H₅, R2=H (0.25ccm) | R1=CH₃, R2=CH₃ (0.5ccm) | R1=H, R2=CH(CH₃)₂ (0.4ccm) | R1=H, R2=GH₃ (0.4ccm) | R1=NHCH₃, R2=H (1.0ccm) | R1=C₂H₅, R2=CH₃ (0.3ccm) |
| | Carrier Gas | He: 300sccm | Ar::400sccm | He: 500sccm | He: 500sccm | N₂: 1000sccm | He: 750sccm |
| | RF | 9540W/m² | 6360W/m² | 15900W/m² | 4770W/m² | 31800W/m² | 7950W/m² |
| | LF | 636W/² | 318W/m² | 1590W/m² | 0W/m² | 3180W/m² | 795W/m² |
| | Pressure | 20mmTorr | 15mmTorr | 30mmTorr | 10mmTorr | 50mmTorr | 15mmTorr |
| | Substrate Temperature | 250°C | 280°C | 180°C | 200°C | 320°C | 200°C |
| | Time | 90sec. | 35sec. | 50sec. | 45sec. | 20sec. | 50sec. |
| Reaction Promoting Step | Carrier Gas | N₂: 300sccm | Ar: 1000sccm | He: 300sccm | He: 900sccm | Ar: 500sccm | He: 900sccm |
| | RF | 15900W/m² | 31800W/m² | 6360W/m² | 47700W/m² | 15900W/m² | 31800W/m² |
| | LF | 12720W/m² | 15900W/m² | 6360W/m² | 9540W/m² | 47700W/m² | 31800W/m² |
| | Pressure | 20mm Torr | 30mmTorr | 15mmTorr | 20mmTorr | 25mmTorr | 20mmTorr |
| | Substrate Temperature | 250°C | 280°C | 360°C | 350°C | 375°C | 350°C |
| | Time | 120sec. | 150sec. | 180sec. | 300sec. | 240sec. | 180sec, |
| | UV Wavelength | --- | --- | --- | --- | --- | --- |
| | UV Power | --- | --- | --- | --- | --- | --- |
| | UV Radiation Time | --- | --- | --- | --- | --- | --- |
| | Electron Beam Radiation Amount | --- | --- | --- | --- | --- | --- |
| | Electron Beam Radiation time | --- | --- | --- | --- | --- | --- |
| Film Characteristics | Permittivity (Value after 2 weeks) | 2.57(2.63) | 2.40(2.40) | 2.90(2.95) | 2.21 (2.25) | 2.38(2.38) | 2.10(2.12) |
| | Leak Current (2 MV/cm) | 1.3E-11A/cm² | 7.5E-10A/cm² | 8.2E-9A/cm² | 2.5E-11A/cm² | 4.9E-10A/cm² | 2.5E-11A/cm² |
| | Young' s Modulus | 311GPa | 40GPa | 52GPa | 23GPa | 20GPa | 35GPa |
| | Hardness | 2.3GPa | 3.2GPa | 4.5GPa | 1.9GPa | 1.5GPa | 2.6GPa |
| | Bonding Strength | 20J/m² | 17J/m2² | 25J/m² | 19J/m² | 12J/m² | 30J/m² |
| Film Evaluation | IR B/A | 0 | 0.1 | 0.2 | 0.1 | 0.3 | 0.2 |
| | Raman D/(G+D) | 0.5 | 0.5 | 0.6 | 0.4 | 0.6 | 0.4 |
| | XPS B(eV) | 190.5 | 189.5 | 190.3 | 189.3 | 191 | 190.2 |
| | XPS N(eV) | 398 | 397 | 398.7 | 397.8 | 397.3 | 398.2 |
| | UPS C(eV) | 284.5 | 284.7 | 283.6 | 285.5 | 283.9 | 284.7 |
| | XPS O(at.%) | 3.6 | 4.1 | 2.8 | 3.8 | 4.2 | 6.8 |
| Remarks | | | | | | | |

**[Table 1-2]**

| | | Example 7 | Example 8 | Example 9 | Example 10 | Examples 11 | Example 12 |
|---|---|---|---|---|---|---|---|
| Film Forming Step | Raw Material | R1=H, R2=CH₃ (0.5ccm) | R1=C₂H_{5,} R2=CH₃ (0.4ccm) | R1=CH₃, R2=H (0.25ccm) | R1=H. R2=CH(CH₃)₂ (0.6ccm) | R1=N(CH₃)₂, R2=CH₃ (1.0ccm) | R1=C₂H₅, R2=H (0.25ccm) |
| | Carrier Gas | N₂: 300sccm He:300sccm | NH₃: 200sccm He: 400sccm | CH₄: 50sccm Ar: 550sccm | H₂: 100sccm N₂: 500sccm | O₂: 25sccm Ar: 575sccm | He: 300sccm |
| | RF | 12720W/m² | 23850W/m² | 6360W/m² | 15900W/m² | 7950W/m² | 9540W/m² |
| | LF | 1590W/m² | 954W/m² | 0W/m² | 318W/m² | 2385W/m² | 636W/m² |
| | Pressure | 15mmTorr | 20mmTorr | 10mmTorr | 30mmTorr | 20mmTorr | 20mmTorr |
| | Substrate Temperature | 280°C | 300°C | 240°C | 350°C | 260°C | 250°C |
| | Time | 60sec. | 75sec. | 90sec. | 50sec. | 50sec. | 90sec. |
| Reaction Promoting Step | Carrier Gas | He: 500sccm | He: 1200sccm | Ar: 750sccm | N₂: 500sccm | He:300sccm | --- |
| | RF | 31800W/m² | 47700W/m² | 31800W/m² | 47700W/m² | 15900W/m² | --- |
| | LF | 15900W/m² | 31800W/m² | 6360W/m² | 47700W/m² | 31800W/m² | --- |
| | Pressure | 10mmTorr | 40mmTorr | 25mmTorr | 15mmTorr | 10mmTorr | --- |
| | Substrate Temperature | 280°C | 400°C | 320°C | 380°C | 300°C | 300°C |
| | Time | 150sec. | 300sec. | 200sec. | 500sec. | 180sec. | 300sec. |
| | UV Wavelength | --- | --- | --- | --- | --- | --- |
| | UV Power | --- | --- | --- | --- | --- | --- |
| | UV Radiation Time | --- | --- | ---- | --- | --- | --- |
| | Electron Beam Radiation Amount | --- | --- | --- | --- | --- | --- |
| | Electron Beam Radiation Time | --- | --- | --- | --- | --- | --- |
| Film Characteristics | Permittivity weeks) | 2.32(2.33) | 2.54(2.59) | 2.72(2.75) | 2.60(2.65) | 2.44(2.45) | 2.65(2.72) |
| | (Value after 2 Leak Current (2 MV/cm) | 3.4E-10A/cm² | 7.6E-09A/cm² | 5.9E-10A/cm² | 4.6E-9A/cm² | 8.3E-11A/cm² | 3.2E-11A/cm² |
| | Young's Modulus | 37GPa | 42GPa | 52GPa | 33GPa | 36GPa | 28spa |
| | Hardness | 2.8GPa | 3.2GPa | 2.3GPa | 2.3GPa | 2.7GPa | 2.6GPa |
| | Bonding Strength | 25J/m² | 24J/m² | 2tJ/m² | 30J/m² | 20J/m² | 18J/m² |
| Film Evaluation | IR B/A | 0.4 | 0.4 | 0.2 | 0.3 | 0.4 | 0.2 |
| | Raman D/(G+D) | 0.5 | 0.5 | 0.4 | 0.5 | 0.5 | 0.6 |
| | XPS B(eV) | 189.8 | 190.1 | 189 | 190.6 | 189.7 | 190.1 |
| | XPS N(eV) | 398.6 | 397.4 | 399 | 397.8 | 398.1 | 398.3 |
| | XPS C(eV) | 284.1 | 283.1 | 285.4 | 283 | 285.1 | 283.7 |
| | XPS 0(at.%) | 5.1 | 10 | 4.8 | 8.5 | 7.2 | 7.6 |
| Remarks | | | | | | | |

**[Table 1-3]**

| | | Example 13 | Example 14 | Example 15 | Comparative Example 1 | Comparative Example2 | Comparative Example3 |
|---|---|---|---|---|---|---|---|
| Film Forming Step | Raw Material | R1=O₂H₅, R2=H (0.25ccm) | R1=C₂H₅, R2=H (0.25cm) | R1=C₂H₅ R2=H (0.25cm) | R1=H, R2=H (0.3ccm) | R1=C₂H₅, R2=CH₃ (0.3ccm) | R1=C₂H₅, R2=CH₃ (0.3ccm) |
| | Carrier Gas | He: 300sccm | He: 300sccm | He: 300sccm | He: 750sccm | He: 750sccm | He: 750sccm |
| | RF | 9540W/m² | 9540W/m² | 9540W/m² | 7950W/m² | 7950W/m² | 7950W/m² |
| | LF | 636W/m² | 636W/m² | 636W/m² | 795W/m² | 795W/m² | 795W/m² |
| | Pressure | 20mmTorr | 20mmTorr | 20mmTorr | 15mmTorr | 15mmTorr | 15mmTorr |
| | Substrate Temperature | 250°C | 250°C | 250°C | 200°C | 200°C | 200°C |
| | Time | 90sec. | 90sec. | 90sec. | 50sec. | 50sec. | 50sec. |
| Reaction Promoting Step | Carrier Gas | --- | --- | ①--- ②N2:300sccm | He: 900sccm | None | He: 900sccm |
| | RF | --- | --- | ①--- ②15900W/m2 | 31800W/m² | | 31800W/m² |
| | LF | --- | --- | ①--- ②12720W/m² | 31800W/m² | | 1430W/m² |
| | Pressure | --- | --- | ①--- ②20mTorr | 20mmTorr | | 20mmTorr |
| | Substrate Temperature | --- | --- | ①300°C ②250°C | 350°C | | 350°C |
| | Time | --- | --- | ①120sec. ②90sec. | 180sec. | | 180sec. |
| | UV Wavelength | 380nm | --- | --- | --- | --- | --- |
| | UV Power | 2mW/cm2 | --- | | --- | --- | --- |
| | UV Radiation Time | 120sec. | --- | --- | --- | --- | --- |
| | Electron Beam Radiation Amount | --- | 0.5mA/cm2 | --- | --- | --- | --- |
| | Electron Beam Radiation Time | --- | 30sec. | --- | --- | --- | --- |
| Film Characteristics | Permittivity (Value after 2 weeks) | 2.55(2.61) | 2.59(2.65) | 2.51(2.59) | 3.63(5.17) | 4.20(7.53) | 4.0(6.82) |
| | Leak Current (2 MV/cm) | 1.8E-11A/cm² | 2.2E-11A/cm² | 1.1E-11A/cm² | 3.2E-7A/cm² | 9.3E-6A/C² | 8.3E-6A/cm² |
| | Young' s modulus | 38GPa | 30GPa | 35GPa | 9GPa | 6spa | 6GPa |
| | Hardness | 3.7spa | 2.1GPa | 3.3GPa | 0.8GPa | 0.5GPa | 0.5GPa |
| | Bonding Strength | 25J/m² | 20J/m² | 23J/m² | 7J/m² | 5J/m² | 6J/m² |
| Film Evaluation | IR B/A | 0.1 | 0.1 | 0 | 0.6 | 0.7 | 0.6 |
| | Roman D/(G+D) | 0.4 | 0.4 | 0.5 | 0.7 | 0.3 | 0.3 |
| | XPS B(eV) | 189.5 | 189.7 | 190.2 | 192.2 | 192 | 192.2 |
| | XPS N(eV) | 397.7 | 397.4 | 398.1 | 399.2 | 396.5 | 399.5 |
| | XPS C(eV) | 285.2 | 285 | 284.5 | 286 | 286 | 286 |
| | XPS O(at.%) | 8.5 | 9.1 | 3.1 | 28.3 | 25 | 26.2 |
| Remarks | | | | Plasma Treatment After Thermal Treatment | | | |

### INDUSTRIAL APPLICABILITY

The insulating film for the semiconductor device according to the present invention is suitable for an interlayer insulating film of a semiconductor device and can be also applied to a barrier metal layer, etch stopper layer, passivation film, hard mask, etc. of semiconductor devices.

## Claims

1. A manufacturing method of a semiconductor device, comprising:
a film forming step of supplying a mixed gas containing a carrier gas and a rawmaterial gas, which is a gasified material having borazine skeletal molecules shown in a chemical formula described below, into a chamber,
causing electromagnetic waves to enter the chamber so as to cause the mixed gas to be in a plasma state, and
carrying out gas-phase polymerization by using the borazine skeletal molecule as a fundamental unit so as to form an insulating film for the semiconductor device on a substrate placed in the chamber; and
a reaction promoting step of promoting cross-linking reaction of the borazine skeletal molecules in the formed insulating film for the semiconductor device after the film forming step. 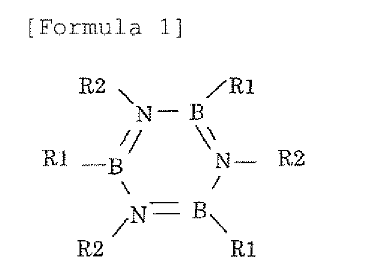 Herein, each of R1 and R2 in the above described chemical formula is a hydrogen atom or an alkyl group, an alkenyl group, a monoalkyl amino group, or a dialkylamino group, which are having a carbon number of 5 or less, and R1 and R2 may be the same or different from each other. However, the cases in which all of R1 and R2 are hydrogen atoms are excluded.

2. The manufacturing method of the semiconductor device according to claim 1, wherein
the carrier gas comprises a gas of at least one species of helium, argon, nitrogen, hydrogen, oxygen, ammonia, and methane and may be the same or different in the film forming step and the reaction promoting step.

3. The manufacturing method of the semiconductor device according to claim 1 or claim 2, wherein
in the film forming step, a bias is applied to the substrate.

4. The manufacturing method of the semiconductor device according to claim 3, wherein
power of the bias in the film forming step is equal to or less than 3180 W/m².

5. The manufacturing method of the semiconductor device according to any of claims 1 to 4, wherein
in the reaction promoting step, a bias is applied to the substrate, and
the cross-linking reaction of the borazine skeletal molecules in the formed insulating film for the semiconductor device is promoted by plasma mainly comprising a gas not containing the raw material gas.

6. The manufacturing method of the semiconductor device according to any of claims 1 to 4, wherein
in the reaction promoting step, a bias is applied to the substrate,
only the raw material gas, which is the gasified material having the borazine skeletal molecules, is gradually reduced while supplying the mixed gas, and
the cross-linking reaction of the borazine skeletal molecules in the formed insulating film for the semiconductor device is promoted by plasma mainly comprising the carrier gas.

7. The manufacturing method of the semiconductor device according to claim 5 or claim 6, wherein
power of the bias in the reaction promoting step has magnitude different from the bias in the film forming step, and the product of the power and application time is equal to or more than 95550 W/m²·second.

8. The manufacturing method of the semiconductor device according to claim 5 or claim 6, wherein
power of the electromagnetic waves in the film forming step and the reaction promoting step is equal to or more than 1590 W/m² and equal to or less than 127400 W/m².

9. The manufacturing method of the semiconductor device according to any of claims 1 to 8, wherein
the substrate is disposed at a height position where an electron density in the vicinity of the substrate is equal to or less than one twentieth of a highest electron density in the plasma.

10. The manufacturing method of the semiconductor device according to any of claims 1 to 4, wherein
in the reaction promoting step, the cross-linking reaction of the borazine skeletal molecules in the formed insulating film for the semiconductor device is promoted by thermal treatment.

11. The manufacturing method of the semiconductor device according to any of claims 1 to 4, wherein
in the reaction promoting step, the Gross-linking reaction of the borazine skeletal molecules in the formed insulating film for the semiconductor device is promoted by ultraviolet ray radiation treatment.

12. The manufacturing method of the semiconductor device according to any of claims 1 to 4, wherein
in the reaction promoting step, the cross-linking reaction of the borazine skeletal molecules in the formed insulating film for the semiconductor device is promoted by electron beam radiation treatment.

13. The manufacturing method of the semiconductor device according to any of claims to 4, wherein
in the reaction promoting step, the cross-linking reaction of the borazine skeletal molecules in the formed insulating film for the semiconductor device is promoted by ion radiation treatment.

14. A semiconductor device manufacturing apparatus, comprising:
gas supplying means for supplying a mixed gas containing a carrier gas and a raw material gas, which is a gasified material having borazine skeletal molecules shown in a chemical formula described below, into a chamber;
plasma generating means for causing electromagnetic waves to enter the chamber so as to cause the mixed gas to be in a plasma state;
promoting means for promoting cross-linking reaction of the borazine skeletal molecules; and
controlling means for controlling the gas supplyingmeans, the plasma generating means, and the promoting means; wherein the controlling means
carries out a film forming step of supplying the mixed gas into the chamber by the gas supplying means,
causing the mixed gas to be in the plasma state by the plasma generating means, and
forming a film on a substrate placed in the chamber as an insulating film for the semiconductor device by carrying out gas-phase polymerization by using the borazine skeletal molecule as a fundamental unit; and
carries out a reaction promoting step of promoting the cross-linking reaction of the borazine skeletal molecules in the formed insulating film for the semiconductor device by the promoting means after the film forming step. 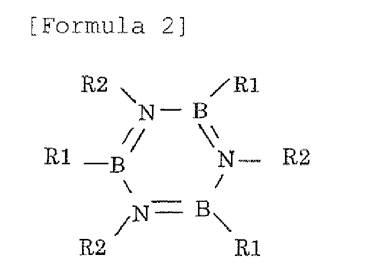 Herein, each of R1 and R2 in the above described chemical formula is a hydrogen atom or an alkyl group, an alkenyl group, a monoalkylamino group, or a dialkylamino group, which are having a carbon number of 5 or less, and R1 and R2 may be the same or different from each other. However, the cases in which all of R1 and R2 are hydrogen atoms are excluded.

15. The semiconductor device manufacturing apparatus according to claim 14, wherein
the carrier gas comprises a gas of at least one species of helium, argon, nitrogen, hydrogen, oxygen, ammonia, and methane and may be the same or different in the film forming step and the reaction promoting step.

16. The semiconductor device manufacturing apparatus according to claim 14 or claim 15, further comprising:
bias applying means for applying bias to the substrate,
wherein the controlling means applies the bias to the substrate by the bias applying means in the film forming step.

17. The semiconductor device manufacturing apparatus according to claim 16, wherein
the bias applying means causes power of the bias in the film forming step to be equal to or less than 3180 W/m².

18. The semiconductor device manufacturing apparatus according to any of claims 14 to 17, wherein
as the promoting means in the reaction promoting step,
the controlling means applies a bias to the substrate by the bias supplying means,
generates plasma mainly comprising a gas not containing the raw material gas by the gas supplying means and the plasma generating means, and
promotes the cross-linking reaction of the borazine skeletal molecules in the formed insulating film for the semiconductor device by the plasma.

19. The semiconductor device manufacturing apparatus according to any of claims 14 to 17, wherein
as the promoting means in the reaction promoting step,
the controlling means applies a bias to the substrate by the bias applying means,
gradually reduces only supply of the raw material gas, which is the gasified borazine skeletal molecules, by the gas supplying means,
generates plasma mainly comprising the carrier gas by the plasma generating means, and
promotes the cross-linking reaction of the borazine skeletal molecules in the formed insulating film for the semiconductor device by the plasma.

20. The semiconductor device manufacturing apparatus according to claim 18 or claim 19, wherein
the bias applying means causes power of the bias in the reaction promoting step to have magnitude different from the bias in the film forming step and causes the product of the power and application time to be equal to or more than 95550 W/m²·second.

21. The semiconductor device manufacturing apparatus according to any of claims 14 to 20, wherein
the plasma generating means causes power of the electromagnetic waves in the film forming step and the reaction promoting step to be equal to or more than 1590 W/m² and equal to or less than 127400 W/m².

22. The semiconductor device manufacturing apparatus according to any of claims 14 to 21, further comprising:
lifting/lowering means for changing a height position of the substrate,
wherein the lifting/lowering means disposes the substrate at a height position where an electron density in the vicinity of the substrate is equal to or less than one twentieth of a highest electron density in the plasma.

23. The semiconductor device manufacturing apparatus according to any of claims 14 to 17, further comprising:
thermal treatment means for performing thermal treatment to the substrate as the promoting means,
wherein in the reaction promoting step, the cross-linking reaction of the borazine skeletal molecules in the formed insulating film for the semiconductor device is promoted by the thermal treatment by the thermal treatment means.

24. The semiconductor device manufacturing apparatus according to any of claims 14 to 17, further comprising:
ultraviolet ray radiation means for irradiating the substrate with ultraviolet rays as the promoting means,
wherein in the reaction promoting step, the cross-linking reaction of the borazine skeletal molecules in the formed insulating film for the semiconductor device is promoted by ultraviolet ray radiation by the ultraviolet ray radiation means.

25. The semiconductor device manufacturing apparatus according to any of claims 14 to 17, further comprising:
electron beam radiation means for irradiating the substrate with an electron beam as the promoting means,
wherein in the reaction promoting step, the cross-linking reaction of the borazine skeletal molecules in the formed insulating film for the semiconductor device is promoted by electron beam radiation by the electron beam radiation means.

26. The semiconductor device manufacturing apparatus according to any of claims 14 to 17, further comprising:
ion radiation means for irradiating the substrate with ions as the promoting means,
wherein in the reaction promoting step, the cross-linking reaction of the borazine skeletal molecules in the formed insulating film for the semiconductor device is promoted by ion radiation by the ion radiation means.

27. An insulating film for a semiconductor device, comprising:
a borazine skeletal structure, wherein
in infrared absorption measurement of the borazine skeletal structure, a ratio [B/A] of an absorption peak intensity A at wave numbers of 1200 to 1600 cm⁻¹ and an absorption peak intensity B at wave numbers of 3000 to 3600 cm⁻¹ in the measurement is equal to or less than 0.5.

28. An insulating film for a semiconductor device, comprising:
a borazine skeletal structure, wherein
in laser Raman spectroscopy measurement of the borazine skeletal structure at an excitation wavelength of 413 nm using Kr laser as a light source, a ratio [D/(D+G)] is equal to or more than 0.4 and equal to or less than 0.6, wherein, in the measurement, an intensity of a spectrum peak of wave numbers of 1100 to 1400 cm⁻¹ is D, and an intensity of a spectrum peak of wave numbers of 1400 to 1700 cm⁻¹ is G.

29. An insulating film for a semiconductor device, comprising:
a borazine skeletal structure, wherein
in X-ray photoelectron spectroscopy measurement of the borazine skeletal structure, the positions of spectrum peaks of boron atoms, nitrogen atoms, and carbon atoms in the film are 189.0 eV to 191.0 eV, 397.0 eV to 399.0 eV, and 283. eV to 285.5 eV, respectively; and the rate of oxygen atoms among constituent elements of the interior of the film is equal to or less than 10%.

30. The insulating film for the semiconductor device according to any of claims 27 to 29, wherein
change of permittivity of the insulating film for the semiconductor device is equal to or less than 0.1 under an environment having a temperature of 25°C and a humidity of 50%Rh.
